# EUROPEAN PATENT APPLICATION

(11) **EP 3 035 383 A1**
(43) Date of publication of application: **22.06.2016**
(21) Application number: 15197988.7
(22) Date of filing: 04.12.2015
(51) Int. Cl.: H01L 23/31, H01L 23/498, H01L 21/56, H01L 25/10

(54) **SEMICONDUCTOR PACKAGE ASSEMBLY**

(30) Priority: 16.12.2014 US 201462092296 P; 23.10.2015 US 201514921015
(71) Applicant: MediaTek, Inc, Hsin-Chu 300 (TW)
(72) Inventor: HSU, Wen-Sung, New Taipei City 231 (TW); LIN, Shih-Chin, Taoyuan City 335 (TW)
(74) Representative: Goddar, Heinz J.

(57) **Abstract**

The invention provides a semiconductor package assembly. The semiconductor package assembly includes a substrate structure having a cavity. A bottom surface of the cavity serves as a die-attach surface of the substrate structure. A semiconductor die is disposed in the cavity and mounted on the die-attach surface. A sidewall of the cavity is separated from the semiconductor die. An interposer is disposed on the substrate structure, covering the cavity.

## Description

### CROSS REFERENCE TO RELATED APPLICATIONS

This application claims the benefit of U.S. Provisional Application No. 62/092,296 filed on December 16, 2014, the entirety of which is incorporated by reference herein.

### BACKGROUND OF THE INVENTION

### Field of the Invention

The present invention relates to a semiconductor package assembly, and in particular to a package-on-package (POP) package assembly.

### Description of the Related Art

Package-on-package (PoP) package assembly is an integrated circuit packaging method to combine vertically discrete system-on-chip (SOC) and memory packages. Two or more packages are installed atop each other, i.e. stacked, with a standard interface to route signals between them. This allows higher component density in devices, such as mobile phones, personal digital assistants (PDAs), and digital cameras.

Due to the increased amount of input/output connections of the bottom SOC package, it is hard to reduce the height between the top memory package and the bottom SOC package.

Thus, a novel semiconductor package assembly is desirable.

### BRIEF SUMMARY OF THE INVENTION

A semiconductor package assembly is provided. An exemplary embodiment of a semiconductor package assembly includes a substrate structure having a cavity. A bottom surface of the cavity serves as a die-attach surface of the substrate structure. A semiconductor die is disposed in the cavity and mounted on the die-attach surface. A sidewall of the cavity is separated from the semiconductor die. An interposer is disposed on the substrate structure, covering the cavity.

Another exemplary embodiment of a semiconductor package assembly includes a substrate structure having a die-attach surface, an interposer-attach surface and a bump-attach surface. The die-attach surface and the interposer-attach surface are opposite to the die-attach surface, respectively. An interposer is disposed on the interposer-attach surface of substrate structure. The substrate structure and the interposer collectively form an accommodation space. A semiconductor die is disposed in the accommodation space and mounted on the die-attach surface.

Yet another exemplary embodiment of a semiconductor package assembly includes a substrate structure having a die-attach surface, an interposer-attach surface and a bump-attach surface. The die-attach surface and the interposer-attach surface are opposite to the bump-attach surface, respectively. An interposer is disposed on the interposer-attach surface of substrate structure. The substrate structure and the interposer collectively form a composite structure having a ring shape in a cross-sectional view. A semiconductor die is disposed within a hollow space of the composite structure and mounted on the die-attach surface.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:

FIGS. 1-3 are cross-sectional views of a semiconductor package assembly in accordance with some embodiments of the disclosure; and

FIGS. 4A-4C are cross-sectional views of a method for fabricating a semiconductor package assembly in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

Embodiments provide a semiconductor package assembly having a package-on-package (POP) structure. The semiconductor package assembly includes a cavity substrate and an interposer thereon. The cavity substrate is provided for a system on chip (SOC) die mounted within the cavity. The interposer is provided for a memory die bonded thereon. The semiconductor package assembly using the cavity substrate may satisfy the requirements of cost-efficiency, high bandwidth, low power and quick transition.

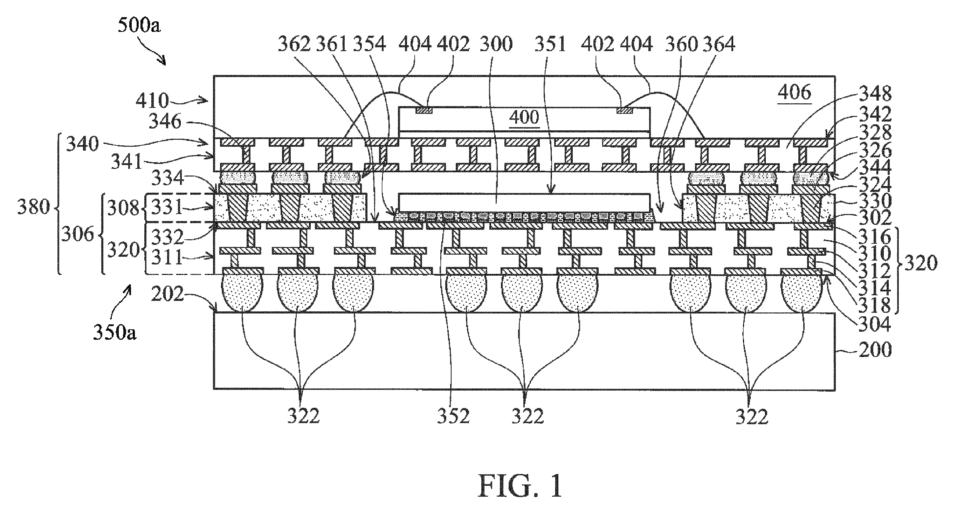

FIG. 1 is a cross-sectional view of a semiconductor package assembly 500a including a system-on-chip (SOC) package 350a and a memory package 410 stacked thereon in accordance with some embodiments of the disclosure. In some embodiments, the semiconductor package assembly 500a is a package-on-package (POP) semiconductor package assembly. The semiconductor package assembly 500a includes at least two vertically stacked wafer-level semiconductor packages mounted on a base 200.

As shown in FIG. 1, the base 200, for example a printed circuit board (PCB), may be formed of polypropylene (PP). It should also be noted that the base 200 can be a single layer or a multilayer structure. A plurality of pads (not shown) and/or conductive traces (not shown) is disposed on a package surface 202 of the base 200. In one embodiment, the conductive traces may comprise power trace segments, signal trace segments or ground trace segments, which are used for the input/output (I/O) connections of the SOC package 350a and the memory package 410. Also, the SOC package 350a is mounted directly on the conductive traces. In some other embodiments, the pads are disposed on the package surface 202, connected to different terminals of the conductive traces. The pads are used for the SOC package 350a mounted directly thereon.

As shown in FIG. 1, the SOC package 350a is mounted on the package surface 202 of the base 200 by a bonding process. The SOC package 350a is mounted on the base 200 through the conductive structures 322. The SOC package 350a includes a substrate structure 306 and a semiconductor die 300 bonding on the substrate structure 306. In one embodiment, the semiconductor die 300 is a system on chip (SOC) die.

As shown in FIG. 1, the substrate structure 306 has an interposer-attach surface 334 and a bump-attach surface 304 opposite to the interposer-attach surface 334. The substrate structure 306 has a cavity 360 formed from the interposer-attach surface 334 into portion of the substrate structure 306. The cavity 360 is substantially positioned in the center portion of the substrate structure 306. The bottom surface 361 of the cavity 360 also serves as a die-attach surface of the substrate structure 306.

As shown in FIG. 1, the substrate structure 306 includes a plate portion 320 and a supporting portion 308. The plate portion 320 has a planar top surface 302 and a planar bottom surface. The bottom surface of the plate portion 320 is also the bump-attach surface 304 of the substrate structure 306. The die-attach surface 361 is a portion of the top surface 302 of the plate portion 320. In one embodiment, the plate portion 320 comprises a core substrate or a coreless substrate. In one embodiment as shown in FIG. 1, the plate portion 320 is a coreless substrate. The plate portion 320 comprises an additional circuit structure comprising one or more dielectric layers 310, conductive traces 312, vias 314 and pads 316 and 318. In one embodiment, the dielectric layer 310 is formed of materials comprising prepreg ("pre-impregnated" composite fibers), polyimide (PI), Ajinomoto build-up film (ABF), poly-p-phenylenebenzobisthiazole (PBO), polypropylene (PP) or molding compounds. The conductive traces 312 and vias 314 are disposed in the dielectric layer 310 by the laser drilling process, the plating process and the photolithography process. The pads 316 and 318 are disposed respectively close to the top surface 302 and the bottom surface 304 by the plating process and the photolithography process. The pads 316 and 318 are electrically connected to the conductive traces 312 and vias 314. Also, the pads 318 close to the bottom surface 304 are electrically connected to conductive structures 322. In one embodiment, the conductive traces 312, the vias 314 and the pads 316 and 318 are formed of metals comprising copper.

As shown in FIG. 1, the supporting portion 308 is disposed on the top surface 302 of the plate portion 320. The supporting portion 308 has a top surface, which is also the interposer-attach surface 334 of the substrate structure 306. The supporting portion 308 also has a bottom surface 332 in contact with the top surface 302 of the plate portion 320. Therefore, Therefore, the die-attach surface 361 (a portion of the top surface 302) is not coplanar with the interposer-attach surface 334 of the substrate structure 306. The supporting portion 308 surrounds a peripheral region of the plate portion 320 to facilitate the cavity 360 formed passing therethrough. The bottom surface 332 is in contact with a peripheral region of the top surface 302 of the plate portion 320. That is to say, the supporting portion 308 does not cover the portion of the top surface 302 of the plate portion 320, which is corresponding to the die-attach surface 361. Also, the supporting portion 308 has an outer sidewall 331 aligned to a sidewall 311 of the plate portion 320. Also, the supporting portion 308 has an inner sidewall 364 serving as a sidewall 364 of the cavity 360.

As shown in FIG. 1, the supporting portion 308 comprises a dielectric layer 330 and at least one conductive structure 324 formed through the dielectric layer 330. In one embodiment, the dielectric layer 330 is a single layer. Also, the dielectric layer 330 is formed of materials comprising prepreg ("pre-impregnated" composite fibers), polyimide (PI), Ajinomoto build-up film (ABF), poly-p-phenylenebenzobisthiazole (PBO), polypropylene (PP) or molding compounds. In one embodiment, the dielectric layer 310 of the plate portion 320 and the dielectric layer 330 of the supporting portion 308 may be formed of the same materials. The conductive structure 324 is electrically connected to the pads 316 of the plate portion 320. In one embodiment, the conductive structure 324 comprises a via, a conductive pillar or a solder ball. In one embodiment, the conductive structure 324 is formed of metals comprising copper or solder. In one embodiment as shown in FIG. 1, when the conductive structure 324 is a copper via, the supporting portion 308 further comprises a pad 326 and a conductive bump 328 disposed on the pad 326. The pad 326 and the conductive bump 328 are on the top surface thereof (the interposer-attach surface 334 of the substrate structure 306) and electrically connected to the conductive structure 324. In one embodiment, the conductive bump 328 comprises a pre-solder, a conductive pillar or a solder ball.

As shown in FIG. 1, the semiconductor die 300 is disposed in the cavity 360 and mounted on the die-attach surface 361 of the substrate structure 306. The width of the semiconductor die 300 can be designed to be less than that of the cavity 360 in a cross section view as shown in FIG. 1. In one embodiment, the sidewall 364 of the cavity 360 is separated from the Semiconductor die 300. Also, the interposer-attach surface 334 of the substrate structure 306 is laterally separated from the semiconductor die 300 in a cross section view as shown in FIG. 1. In one embodiment, the semiconductor die 300 is a Semiconductor die 300 including a logic die including a central processing unit (CPU), a graphic processing unit (GPU), a dynamic random access memory (DRAM) controller or any combination thereof It should be noted that the number of semiconductor dies 300 is not limited to the disclosed embodiment. In one embodiment, the semiconductor die 300 may be fabricated by the through silicon via (TSV) technology or the flip-chip technology. In this embodiment, the semiconductor die 300 is fabricated by the flip-chip technology. Therefore, the semiconductor die 300 has a back surface 351 away from the die-attach surface 361. In one embodiment, the back surface 351 of the semiconductor die 300 is aligned to or lower than the interposer-attach surface 334 of the substrate structure 306. The semiconductor die 300 is electrically connected to the pads 316 of the substrate structure 306 through conductive bumps 352. The conductive bumps 352 are disposed between semiconductor die 300 and the pads 316. In one embodiment, the conductive bumps 352 comprise copper bumps or solder bumps.

As shown in FIG. 1, the SOC package 350a further includes an underfill 354 introduced into a gap between the semiconductor die 300 and the substrate structure 306. The underfill 354 covers a portion of the die-attach surface 361 of the substrate structure 306. In one embodiment, the underfill 354 may comprises a capillary underfill (CUF), molded underfill (MUF) or a combination thereof.

As shown in FIG. 1, the semiconductor package assembly 500a further comprise the memory package 410 stacked on the system-on-chip (SOC) package 350a. In one embodiment, the memory package 410 comprises a wire bonding package, a through hole via (TSV) package or a flip-chip package. In this embodiment, the memory package 410 is a wire bonding package. Alternatively, the memory package 410 may comprise a three-dimensional (3D) semiconductor package by vertically stacking a plurality of memory dies. The memory package 410 comprises an interposer 340 and at least one memory die 400 bonded thereon. The interposer 340 is bonded on the supporting portion 308 of the substrate structure 306. Also, the interposer 340 fully covers the cavity 360 and the interposer-attach surface 334 of the substrate structure 306. The interposer 340 has a die-attach surface 342 and a bump-attach surface 344 opposite to the die-attach surface 344. The die-attach surface 342 is provided for the memory die 400. The bump-attach surface 344 is provided for the conductive structures 322 are bonding to the interposer-attach surface 334 of the substrate structure 306.

In one embodiment, the interposer 340 may comprise a core substrate or a coreless substrate. A sidewall of the interposer 340 is substantially aligned to the outer sidewall 331 of the supporting portion 308 and the sidewall 311 of the plate portion 320. In one embodiment as shown in FIG. 1, the interposer 340 is a coreless substrate. The interposer 340 comprises an additional circuit structure comprising one or more dielectric layers 348 and conductive circuits 346 disposed in the dielectric layer 348. In one embodiment, the conductive circuits 346 may comprise conductive traces vias and pads. In one embodiment, the composition of the interposer 340 may be similar to the plate portion 320. For example, the dielectric layers 348 of the interposer 340 may be similar to the dielectric layers 310 of the plate portion 320. The conductive circuits 346 of the interposer 340 may comprise conductive traces, vias and pads, which are similar to the conductive traces 312, vias 314 and pads 316 and 318 of the plate portion 320. In one embodiment as shown in FIG. 1, the conductive circuits 346 of the interposer 340 are electrically connected to the corresponding conductive bumps 328, which is disposed on the supporting portion 308 with a height. Therefore, a space 362 maybe formed between the interposer 340 and the substrate structure 306. Also, the space 362 may be formed between the conductive bumps 328.

In one embodiment as shown in FIG. 1, the substrate structure 306 and the interposer 340 may collectively form an accommodation space including the cavity 360 in the center portion of the substrate structure 306. The semiconductor die 300 is disposed in the accommodation space including the cavity 360 and mounted on the die-attach surface 361 of the substrate structure 306. In other words, the substrate structure 306 and the interposer 340 bonded thereon collectively form a composite structure 380 substantially having a ring shape in a cross-sectional view as shown in FIG. 1. In one embodiment as shown in FIG. 1, the composite structure 380 may have a hollow space including the cavity 360 in the center portion of the substrate structure 306. The semiconductor die 300 is disposed in the hollow space including the cavity 360 and mounted on the die-attach surface 361 of the substrate structure 306.

In one embodiment, the memory die 400 may comprise a low-power double data rate DRAM (LPDDR DRAM) package following a specific pin assignment rule (such as JEDEC LPDDR I/O Memory specification), or a Wide I/O DRAM die following another specific pin assignment rule (such as JEDEC Wide I/O Memory specification). The memory die 400 is attached on the die-attach surface 342 through a paste (not shown). The memory die 400 coupled to the interposer 340 by bonding wires 404. Terminals of the bonding wires 404 are electrically connected to pads 402 of the memory die 400 and the corresponding conductive circuits 346 of the interposer 340. The memory die 400 further includes a molding material 406 covering the die-attach surface 342 of the interposer 340, encapsulating the memory die 400 and the bonding wires 404.

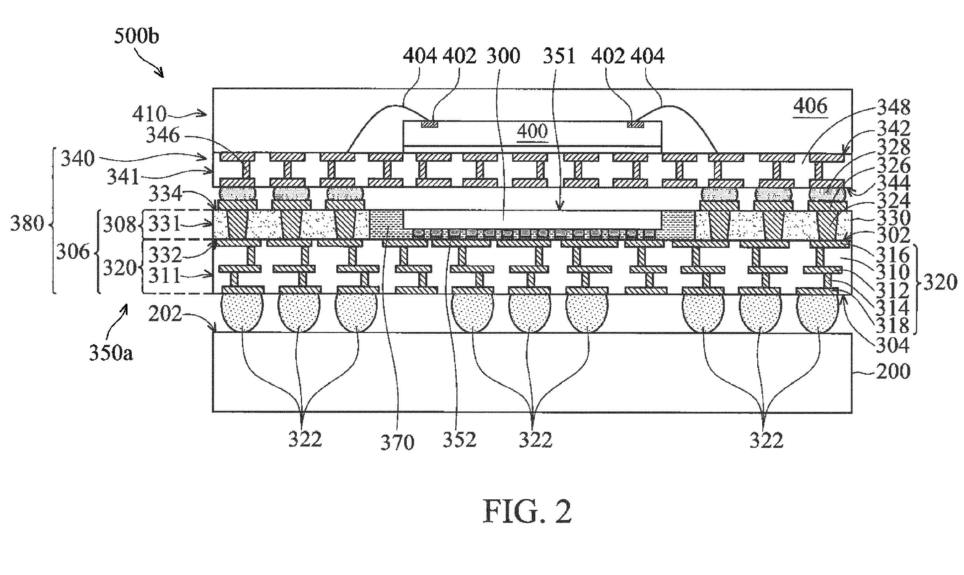

FIG. 2 is a cross-sectional view of a semiconductor package assembly 500b in accordance with some embodiments of the disclosure. Elements of the embodiments hereinafter, that are the same or similar as those previously described with reference to FIG. 1, are not repeated for brevity. The differences between the semiconductor package assembly 500a and the semiconductor package assembly 500b is that the semiconductor package assembly 500b includes a molding compound 370 filling the cavity 360 and the gap between the semiconductor die 300 and the substrate structure 306. The molding compound 370 is in contact with the semiconductor die 300, the sidewall 364 of the cavity 360 and the die-attach surface 361 of the substrate structure 306. The molding compound 370 is separated from the bump-attach surface 344 of the interposer 340. In this embodiment, the back surface 351 of the semiconductor die 300 away from the die-attach surface 361 is exposed from the molding compound 370. The back surface 351 of the semiconductor die 300 may be aligned to the top surface 371 of the molding compound 370, which is away from the die-attach surface 361. Also, the top surface 371 of the molding compound 370 may be aligned to the interposer-attach surface 334 of the substrate structure 306.

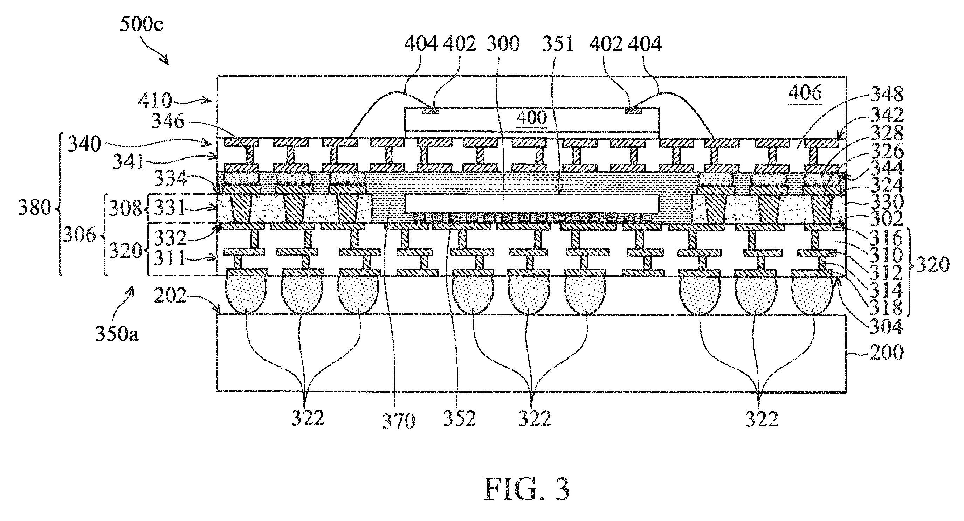

FIG. 3 is a cross-sectional view of a semiconductor package assembly 500c in accordance with some embodiments of the disclosure. Elements of the embodiments hereinafter, that are the same or similar as those previously described with reference to FIGS. 1-2, are not repeated for brevity. The differences between the semiconductor package assembly 500a and the semiconductor package assembly 500c is that the semiconductor package assembly 500b includes a molding compound 372 filling the cavity 360 and the gap between the semiconductor die 300 and the substrate structure 306. The molding compound 372 is in contact with the semiconductor die 300, the sidewall 364 of the cavity 360, the die-attach surface 361 of the substrate structure 306, and the bump-attach surface 344 of the interposer 340. In this embodiment, the molding compound 372 fully covers the semiconductor die 300. Therefore, the back surface 351 of the semiconductor die 300 away from the die-attach surface 361 is fully covered by the molding compound 372. Also, the molding compound 372 fills the space 362 between the interposer 340 and the substrate structure 361. In this embodiment, the molding compound 372 also surrounds the pads 326 and the conductive bumps 328.

The semiconductor package assemblies 500a-500c use the substrate structure having the cavity for a semiconductor die mounted therein. The substrate structure having the cavity can provide a reduced standoff height. The supporting portion of the substrate structure can provide additional interconnections between the SOC package and the memory package. Also, the plate portion of the substrate structure can be formed by coreless substrate to further reduce the standoff height and the fabrication cost. The semiconductor package assembly using the cavity substrate may satisfy the requirements of cost-efficiency, high bandwidth, low power and quick transition.

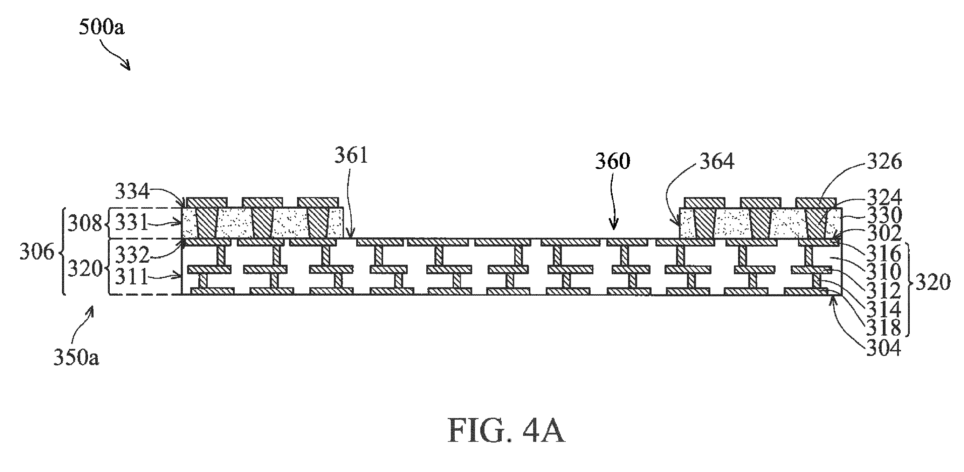

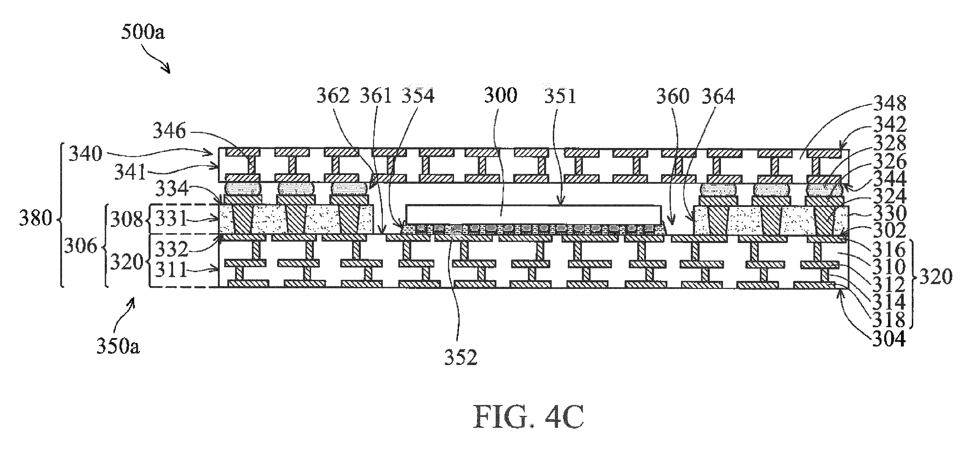

FIGS. 4A-4C are cross-sectional views of a method for fabricating semiconductor package assemblies 500c-500c in accordance with some embodiments of the disclosure. Elements of the embodiments that are the same or similar as those previously described with reference to FIGS. 1-3, are not repeated hereinafter for brevity.

As shown in FIG. 4A, a carrier (not shown) for the substrate structure 306 formed thereon is provided. Next, a laminating process is performed to dispose one or more dielectric layers 310 of the plate portion 320 on the carrier. Next, a drilling process is performed to form openings (not shown) through the dielectric layers 310 to define the positions of the subsequently formed vias 314. In some embodiments, the drilling process may comprise a laser drilling process, an etching drilling process or a mechanical drilling process. Next, a plating process, a photolithography process and an anisotropic etching process are performed to fill a conductive material into the openings to form the conductive traces 312, vias 314 and pads 316, 318 of the plate portion 320. In some embodiments, the plating process may comprise an electrical plating process.

Next, as shown in FIG. 4A, the supporting portion 308 is formed on the top surface 302 of the plate portion 320. The formation processes of the supporting portion 308 can be similar to the formation processes of the plate portion 320. In some embodiments, the supporting portion 308 and the plate portion 320 may be fabricated individually, and then the supporting portion 308 is disposed on the plate portion 320 to form as the substrate structure 306 by the laminating process.

In some other embodiments as shown in FIG. 4A, a piece of substrate including the dielectric layer 330, the conductive structure 324 and/or the pad 326 is disposed on the plate portion 320 by the laminating process. Next, a photolithography process and an anisotropic etching process are performed to remove a center portion of the piece of substrate to form the supporting portion 308 on the plate portion 320. After the aforementioned processes, the substrate structure 306 having the cavity 360 is formed.

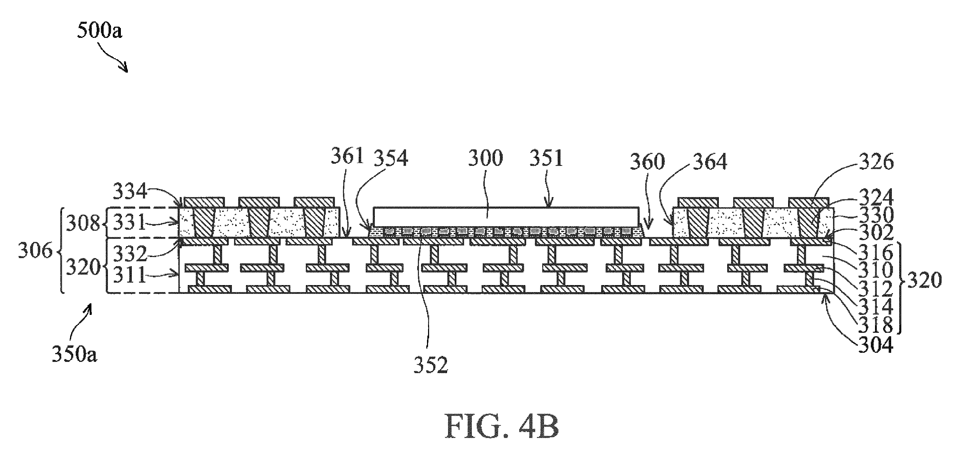

Next, as shown in FIG. 4B, the semiconductor die 300 is flipped and disposed in the cavity 360. The semiconductor die 300 is mounted on the die-attach surface 361 of the substrate structure 306 by the bonding process. The semiconductor die 300 is electrically connected to the pads 316 of the substrate structure 306 through conductive bumps 352.

Next, as shown in FIG. 4B, the interposer 340 is bonded on the supporting portion 308 of the substrate structure 306. The formation processes of the interposer 340 can be similar to the formation processes of the plate portion 320 and the supporting portion 308. In some other embodiments, the conductive bumps 328 can be formed on the corresponding pad 326 of the substrate structure 306 before bonding the interposer 340. The conductive circuits 346 of the interposer 340 are electrically connected to the corresponding conductive bumps 328.

Next, subsequent processes are performed to form the semiconductor package assemblies 500a-500c completely as shown in FIGS. 1-3. In one embodiment as shown in FIG. 1, the underfill 354 may be introduced into the gap between the semiconductor die 300 and the substrate structure 306 after bonding the interposer 340. Alternatively, a coating process maybe performed to fill the molding compound 370 or 371 in the cavity 360 and the gap between the semiconductor die 300 and the substrate structure 306 as shown in FIGS. 2-3. After performing the aforementioned process, the SOC package 350a is fabricated.

After forming the underfill 354 as shown in FIG. 1 or molding compound 370 or 371 as shown in FIGS. 2-3, the conductive structures 322 are formed on the bump-attach surface 304 of the substrate structure 306 by a solder ball fabricating process or a copper pillar fabricating process, as shown in FIGS. 1-3. In some embodiments as shown in FIGS. 1-3, the conductive structures 322 are electrically connected to the corresponding pads 318.

After forming the conductive structures 322 on the bump-attach surface 304 of the substrate structure 306 as shown in FIGS. 1-3, the memory die 400 is attached on the die-attach surface 342 through a paste (not shown). Next, a bonding processes is performed, so that the memory die 400 coupled to the interposer 340 by bonding wires 404, as shown in FIGS. 1-3. Next, a molding process is performed to form the molding material 406 covering the die-attach surface 342 of the interposer 340, encapsulating the memory die 400 and the bonding wires 404, as shown in FIGS. 1-3. In some embodiments, the molding process may comprise the transfer molding process, the sheet molding process or the compression molding process. After performing the molding process, the memory package 410 is fabricated.

Embodiments provide a semiconductor package assembly having a package-on-package (POP) structure and a method for fabricating the semiconductor package assembly. The semiconductor package assembly includes a cavity substrate and an interposer thereon. The cavity substrate is provided for a system on chip (SOC) die mounted within the cavity, so that the standoff height of the semiconductor package assembly can be reduced. The supporting portion of the substrate structure can provide additional interconnections between the SOC package and the memory package. Also, the interposer is bonded on the interposer-attach surface of the substrate structure is provided for a memory die bonded thereon. The substrate structure and the interposer bonded thereon can collectively form a composite structure substantially having a ring shape in a cross-sectional view (FIGS. 1-3). In other words, the composite structure may have a hollow space including the cavity in the center portion of the substrate structure for the semiconductor die disposed therein. Therefore, the die-attach surface is not coplanar with the interposer-attach surface of the substrate structure. The semiconductor package assembly using the cavity substrate may satisfy the requirements of cost-efficiency, high bandwidth, low power and quick transition.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package assembly, comprising:
a substrate structure having a cavity, wherein a bottom surface of the cavity serves as a die-attach surface of the substrate structure;
a semiconductor die disposed in the cavity and mounted on the die-attach surface,
wherein a sidewall of the cavity is separated from the semiconductor die; and
an interposer disposed on the substrate structure, covering the cavity.

2. The semiconductor package assembly as claimed in claim 1, wherein the substrate structure comprises:
a plate portion having a top surface and a bottom surface, wherein the die-attach surface is a portion of the top surface of the plate portion; and
a supporting portion on the top surface of the plate portion, surrounding the semiconductor die, wherein an inner sidewall of the supporting portion is the sidewall of the cavity.

3. The semiconductor package assembly as claimed in claim 2, further comprising an underfill introduced into a gap between the semiconductor die and the substrate structure.

4. The semiconductor package assembly as claimed in claims 2 or 3, further comprising a molding compound filling the cavity, being in contact with the semiconductor die.

5. The semiconductor package assembly as claimed in claim 4, wherein a surface of the semiconductor die away from the die-attach surface is exposed from the molding compound.

6. The semiconductor package assembly as claimed in claim 4, wherein the molding compound fully covers the semiconductor die.

7. The semiconductor package assembly as claimed in claim 6, wherein the molding compound fills a space between the interposer and the substrate structure.

8. The semiconductor package assembly as claimed in one of claims 2 to 7, wherein a surface of the semiconductor die away from the die-attach surface is aligned to or lower than a surface of the supporting portion away from the die-attach surface.

9. The semiconductor package assembly as claimed in one of claims 2 to 8, wherein the plate portion and the interposer comprise a core substrate or a coreless substrate.

10. The semiconductor package assembly as claimed in one of claims 2 to 9, wherein the plate portion comprises an additional circuit structure comprising a dielectric layer and a conductive trace disposed in the dielectric layer.

11. The semiconductor package assembly as claimed in claim 10, wherein the supporting portion comprises a dielectric layer and a conductive structure formed through the dielectric layer.

12. The semiconductor package assembly as claimed in claim 11, wherein the dielectric layer of the plate portion and the dielectric layer of the supporting portion are formed of materials comprising prepreg ("pre-impregnated" composite fibers), polyimide (PI), Ajinomoto build-up film (ABF), poly-p-phenylenebenzobisthiazole (PBO), polypropylene (PP) or molding compounds.

13. The semiconductor package assembly as claimed in claim 11 or 12, wherein the conductive structure comprises a via, a conductive pillar or a solder ball.

14. The semiconductor package assembly as claimed in one of claims 2 to 13, wherein the interposer is bonded on the supporting portion.

15. The semiconductor package assembly as claimed in one of claims 2 to 14, wherein an outer sidewall of the supporting portion is aligned to a sidewall of the plate portion and a sidewall of the interposer.
